# EUROPEAN PATENT APPLICATION

(11) **EP 4 386 483 A1**
(43) Date of publication of application: **19.06.2024**
(21) Application number: 22213728.3
(22) Date of filing: 15.12.2022
(51) Int. Cl.: G03F 7/20, G03F 7/00

(54) **LITHOGRAPHIC APPARATUS THERMAL CONDITIONING SYSTEM AND METHOD**

(71) Applicant: ASML Netherlands B.V., 5500 AH Veldhoven (NL)
(72) Inventor: VAN DE MEERENDONK, Remco, 5500 AH Veldhoven (NL); SWINKELS, Milo, Yaro, 5500 AH Veldhoven (NL); WIJCKMANS, Maurice, Willem, Jozef, Etiënne, 5500 AH Veldhoven (NL); KRABBEN, Ingmar, Gerrit, Willem, 5500 AH Veldhoven (NL); VAN GIESSEN, Cornelis, 5500 AH Veldhoven (NL); JANSSEN, Gerardus, Arnoldus, Hendricus, Franciscus, 5645 KM Eindhoven (NL); WU, Long, 5500 AH Veldhoven (NL); ARORA, Sampann, Veldhoven (NL); SCHIMMEL, Hendrikus, Gijsbertus, 3544 VP Utrecht (NL); FEIJTS, Maurice, Wilhelmus, Leonardus, Hendricus, 6191 GK Beek (NL); PEKELDER, Sven, 5694 VG Breugel (NL); VERVOORDELDONK, Michael, Johannes, 5504 DR Veldhoven (NL); DE LAAT, Kim, Johanna, Mechelina, 5500 AH Veldhoven (NL)
(74) Representative: ASML Netherlands B.V.

(57) **Abstract**

A thermal conditioning system is configured to thermally condition an object. The thermal conditioning system comprises a fluid duct configured to be connected to the object and configured to provide a flow of a thermal conditioning fluid to the object The fluid duct comprises a supply duct configured to be connected to the object and to supply the thermal conditioning fluid to the object and a discharging duct configured to be connected to the object and to discharge the thermal conditioning fluid from the object. The supply duct and the discharging duct are each provided with at least two silencers arranged in series along the supply duct and along the discharging duct respectively.

## Description

### FIELD

The present invention relates to a thermal conditioning system, a lithographic apparatus comprising such thermal conditioning system, and a method of thermally conditioning an object of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Objects of the lithographic apparatus may be provided with a thermal conditioning system, which comprises a fluid duct for guiding a thermal conditioning fluid. The fluid duct is configured to guide the thermal conditioning fluid to the object that is to be thermally conditioned, through the object and to discharge the thermal conditioning fluid from the object. The object may for example be a projection system mirror of a projection system of the lithographic apparatus or may for example be a stage, such as a wafer table of the lithographic apparatus. It has been observed that the thermal conditioning duct may guide disturbances, such as vibrations, to the object. This may be undesirable, as such disturbances may result in e.g. a vibration or other movement of the object. It has been suggested to provide the thermal conditioning duct with a silencer which may provide a compliance in order to suppress the disturbance. A movement of the object, such as a mirror or a substrate table of the lithographic apparatus may result in an inaccuracy in the imaging of a pattern on the substate. The inaccuracy may translate into an overlay error which may adversely affect an accuracy of the lithographic apparatus.

### SUMMARY

It is desired to provide a lithographic apparatus having a high overlay accuracy.

According to an aspect of the invention, there is provided A thermal conditioning system configured to thermally condition an object, wherein the thermal conditioning system comprises a fluid duct configured to be connected to the object and configured to provide a flow of a thermal conditioning fluid to the object, the fluid duct comprising a supply duct configured to be connected to the object and to supply the thermal conditioning fluid to the object and a discharging duct configured to be connected to the object and to discharge the thermal conditioning fluid from the object, wherein the supply duct and the discharging duct are each provided with at least two silencers arranged in series along the supply duct and along the discharging duct respectively.

According to another aspect of the invention, there is provided a lithographic apparatus comprising an object and a thermal conditioning system according to the invention to thermally condition the object, wherein the object is one of a projection system mirror and a substrate table of the lithographic apparatus.

According to yet another aspect of the invention, there is provided a method of thermally conditioning an object of a lithographic apparatus, comprising providing a flow of a thermal conditioning fluid via a fluid duct to the object, wherein the fluid duct is connected to the object and wherein the fluid duct comprises a supply duct connected to the object to supply the thermal conditioning fluid to the object and a discharging duct connected to the object to discharge the thermal conditioning fluid from the object, wherein the supply duct and the discharging duct are each provided with at least two silencers arranged in series along the supply duct respectively along the discharging duct.

According to a still further aspect of the invention, there is provided a method of tuning a silencer in a fluid duct of a thermal conditioning system configured to thermally condition an object, the method comprising defining a disturbance frequency band in which a transfer of a disturbance from a disturbance entry point to the object is to be reduced, providing at least two silencers in the fluid supply duct between the disturbance entry point and the object, providing at least two silencers in the fluid discharging duct between the disturbance entry point and the object, and using the silencers and an inertia of the thermal conditioning fluid between the silencers to provide that a resonance of the mass of the thermal conditioning fluid between the silencers is dimensioned to be at a resonance frequency below the disturbance frequency band.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A and 2B depicts a highly schematic view of a part of a thermal conditioning system according to an aspect of the invention;
- Figure 3A - 3C depict frequency response diagrams based on which an effect of the invention will be explained;
- Figure 4A - 4C depict highly schematic views of embodiments of a silencer as may be employed in the thermal conditioning system according to the invention;
- Figure 5 depicts a highly schematic view of another embodiment of a silencer as may be employed in the thermal conditioning system according to the invention;
- Figure 6 depicts a highly schematic view of a membrane of a silencer as may be employed in the thermal conditioning system according to the invention;
- Figure 7 depicts a highly schematic view of yet another embodiment of a silencer as may be employed in the thermal conditioning system according to the invention;
- Figure 8 depicts a highly schematic view of still yet another embodiment of a silencer as may be employed in the thermal conditioning system according to the invention;
- Figures 9 and 10 depict a highly schematic views of negative compliance mechanisms as may be employed in a silencer;
- Figure 11 depicts a highly schematic view of another embodiment of a thermal conditioning system according to the invention;
- Figure 12A - 12C depict detailed views of yet other embodiments of a thermal conditioning system according to the invention.

### DETAILED DESCRIPTION

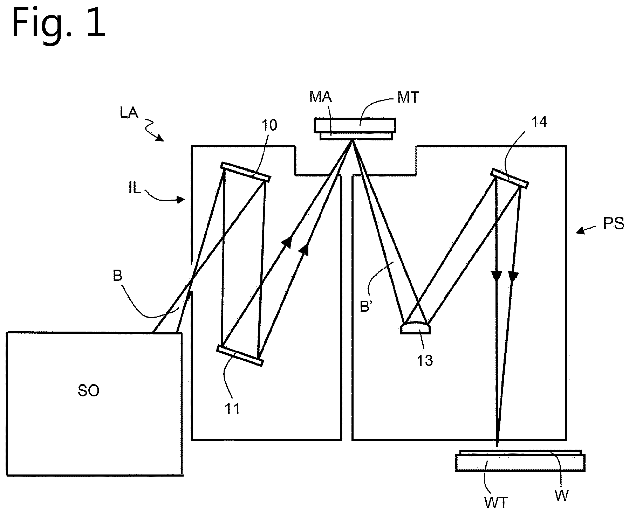

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

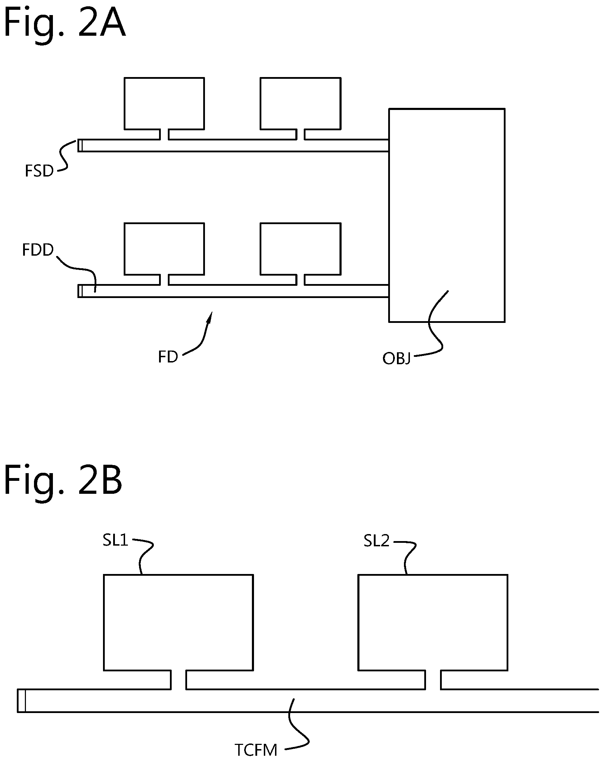

Figure 2A depicts a highly schematic view of a thermal conditioning system which comprises a fluid duct FD connected to an object OBJ. The thermal conditioning system is configured to thermally condition the object. The fluid duct comprises a thermal conditioning fluid supply duct FSD to supply a thermal conditioning fluid to the object OBJ and a thermal conditioning fluid discharging duct FDD, to discharge the thermal conditioning fluid from the object OBJ. The fluid duct may form a fluid flow passage in or on the object, e.g. a fluid channel in the object or a fluid duct on the object, e.g. at a rear side of the object. The thermal conditioning fluid may be formed by any suitable fluid, such as a liquid, e.g. water or a gas. The thermal conditioning system may be configured to heat the object, to cool the object, thereby to provide that the object is stabilized at a desired temperature or within a desired temperature range. The object may for example be a mirror of a lithographic apparatus projection system or a stage, such as a wafer table of a lithographic apparatus. The thermal conditioning fluid may be supplied by any suitable supply means, such as a pump, a pressurizing means, etc.

Figure 2B depicts a schematic view of a part of the fluid supply duct of the thermal conditioning system in accordance with Figure 2A. According to an aspect of the present invention, the fluid supply duct and the fluid discharging duct are each provided with two silencers SL. The silencers may be understood as elements with a low hydraulic stiffness compared to a hydraulic stiffness of the thermal conditioning duct. The hydraulic stiffness may be understood as a ratio of increment in pressure relative to an increment in displaced volume of fluid, K_hyd=dp/dV, wherein p is an absolute pressure, V is a volume of gas.

A silencer as such has been observed to provide a damping to suppress disturbances. A silencer as such may provide a suppression of disturbances by e.g. a factor of 10 to a factor of 30. The inventors have however devised that a substantially higher suppression of disturbances may be achieved making use of such a silencer, which suppression may be orders of magnitude higher as compared to the known suppression by a factor of e.g. 10 to 30.

Reverting to Figure 2B, as explained above, according to an aspect of the present invention, at least two silencers are provided in the supply duct and at least two silencers are provided in the return duct. The silencers SL1, SL2 are arranged in series along the supply duct as well as along the discharging duct. Thus, along the supply duct, one of the at least two silencers is upstream in respect of the other one of the at least two silencers. Similarly, along the discharging duct, one of the at least two silencers is upstream in respect of the other one of the at least two silencers. The thermal conditioning fluid between the silencers SL1, SL2 provides for a thermal conditioning fluid mass TCFM.

The inventors have devised that the assembly of the two silencers in series with the thermal conditioning fluid in the duct between the silencers forming the thermal conditioning fluid mass, may provide a resonance behavior resulting in a roll off above the resonance frequency. By dimensioning the silencers, the compliance thereof and the thermal conditioning fluid mass between the silencers, the resonance frequency may be determined to be below a disturbance frequency band, hence enabling to more effectively suppress disturbances in the disturbance frequency band from being transferred via the fluid duct to the object.

According to an aspect of the invention, there is provided a method of tuning a silencer in a fluid duct of a thermal conditioning system configured to thermally condition an object, the method comprising defining a disturbance frequency band in which a transfer of a disturbance from a disturbance entry point to the object is to be reduced, providing at least two silencers in the fluid supply duct between the disturbance entry point and the object, providing at least two silencers in the fluid discharging duct between the disturbance entry point and the object, and using the silencers and an inertia of the thermal conditioning fluid between the silencers to provide that a resonance of the inertia of the thermal conditioning fluid between the silencers is dimensioned to be at a resonance frequency below the disturbance frequency band.

The present invention outlines the use of multiple silencers in series with a capability to be effective up to higher frequencies (e.g. above 80Hz). Using at least two silencers in series, a gas volume of each silencer effectively creates a low-stiffness in the water circuit by generating a low hydraulic stiffness (K_hyd=dp/dV). Subsequently, the hydraulic stiffness of a gas volume can be derived to be K_hyd=yp/V (adiabatic conditions). In the above formulas, γ (gamma) is an adiabatic index, p is an absolute pressure, V is a volume of gas. By placing two silencers in series the mass in-between the silencers may start to resonate at a resonance frequency. Below this frequency there may be no additional benefit of multiple silencers, at this frequency there may be an amplification, however, above this frequency the mass in-between the silencers may start to decouple and effectively a -2 slope is gained. This is analogous with a mechanical mass-spring isolation system. In this way a significantly higher suppression may be reached by placing multiple silencers in series. Additionally by either decreasing the stiffness of the silencer (decreasing pressure or increasing gas volume) or increasing the hydraulic mass of the duct between the silencers M_(hyd duct)=ρL/A (increasing the length or decreasing the duct cross sectional area), this resonance frequency may be lowered, such that a higher reduction is achieved (especially relevant around the above mentioned frequency, e.g. 80Hz). Placing more than 2 silencers in series may be applied to create multiple masses in-between silencers that start to decouple, such that effectively a -4 slope or even higher may be reached. Tuning the stiffness of the silencer and the hydraulic mass of the duct between the silencers allows to effectively avoid amplification of resonances and to gain ultimo silencing performance. Placing multiple silencers in series with a sufficient distance in-between is currently the critical technology breakthrough for the introduction of DCM from a dynamics perspective.

Effectivity up to higher frequencies: The distance between the gas volume and the duct may limit the frequency up to which effective use of the gas volume may be obtained. This duct part is referred to as the neck of the silencer and the associated resonance frequency may be referred to as the Helmholtz frequency f_HR. Below this frequency the gas volume is effectively felt, at this frequency an additional suppression may be reached (low effort needed to compress gas volume) and above this frequency the gas volume is not effectively felt anymore. By either increasing the stiffness of the silencer (increasing pressure or decreasing gas volume) or decreasing the hydraulic mass of the neck of the silencers (decreasing the length or increasing the neck diameter), this resonance frequency may be increased, such that the gas volume is effectively felt for higher frequencies (especially relevant around 80Hz). To eliminate the risk of gas being dissolved over time a compliant interface is added. The requirement for this interface is that its stiffness is sufficiently low such that the sum of both the gas volume stiffness and that of the compliant interface still may still meet requirements. In addition the inertia of the bellow may be small enough such that the Helmholtz frequency may stay sufficiently high. Finally the structural resonance of the compliant interface may be sufficiently high, at least higher than the Helmholtz frequency, such that it doesn't deteriorate acoustic silencing performance.

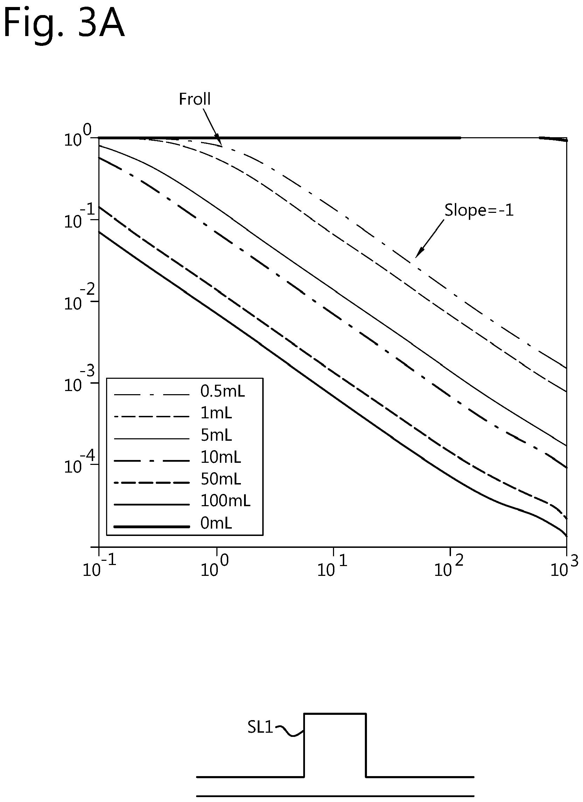

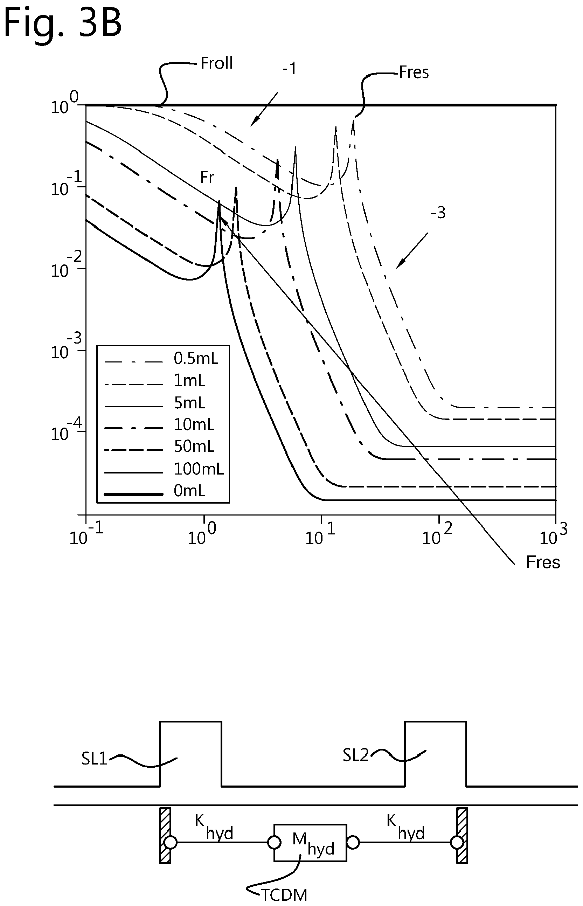

Figure 3A and 3B depicts diagrams where a transfer of a disturbance via the duct to the object is depicted on the vertical axis versus frequency on the horizontal axis. As depicted in Figure 3A, a single silencer in the supply duct FSD and in the return duct FRD provides, above a roll-off frequency Froll, a roll off of a factor 2 per octave, i.e. a factor 10 per frequency decade. As depicted in Figure 3B, two silencers in series in the supply duct and in the return duct may provide for a roll off of a factor 2 per octave from a roll of frequency Froll to a resonance frequency Fres, while providing a triple roll off, i.e. a roll off of a factor 8 per octave above the resonance frequency. The resonance frequency Fres may be determined by the resonance of the dual silencers with the mass of the thermal conditioning fluid in the duct between the two silencers.

Thus, as follows from the above, a single silencer in combination with a non-reflective acoustic boundary condition (critically damped), may provide a -1 slope, i.e. a factor 10 per frequency decade. Dual silencers in series may provide a -3 slope, i.e. a factor 1000 per frequency decade (-1 slope, i.e. the factor 10 per frequency decade may stem from the silencer in combination with a non-reflective acoustic boundary condition, -2 slope, i.e. a factor 100 per frequency decade, may stem from the decoupled mass in between the silencers).

In an embodiment, the at least two silencers form a resonator with the thermal conditioning fluid in the fluid duct interconnecting the at least two silencers. The thermal conditioning fluid in the duct interconnecting the at least two silencers in the supply duct respectively in the return duct, provides for a mass, while the silencers provide for a compliance. The mass of the thermal conditioning fluid between the silencers and the compliance of the silencers may exhibit a resonance behavior, as shown in Figure 3B by the resonance frequency Fres. A resonance behavior implies that two poles are involved in the frequency behavior, as a result if which, above the resonance frequency, a (further) roll off a factor 4 per octave is observed, i.e. a (further) factor 100 per frequency decade. In combination with the roll of the silencer in combination with the non-reflective acoustic boundary condition, a total of a factor 1000 per frequency decade is observed. The resonance frequency may be a resonance due to sloshing of the fluid in the duct between the silencers.

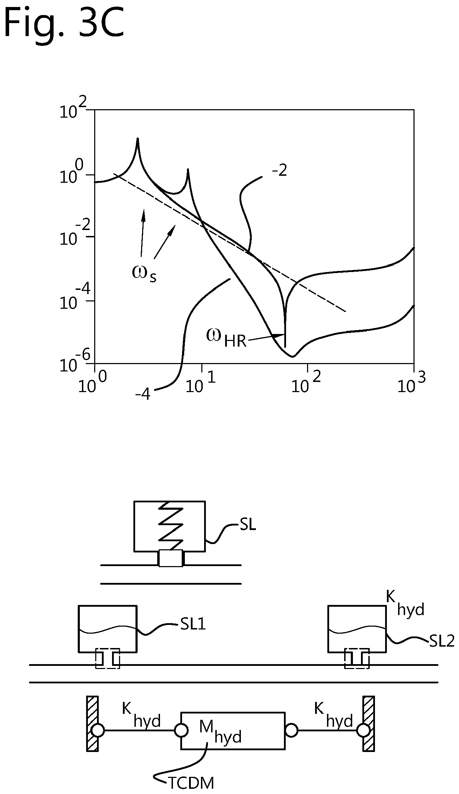

Figure 3C depicts a frequency diagram wherein a transfer of a disturbance via the duct to the object is depicted on the vertical axis versus frequency on the horizontal axis. As depicted in Figure 3C, a single silencer SL as such, in e.g. the supply duct and/or in the return duct, provides a Helmholz resonance at a Helmholz resonance frequency dip ω_{HR} at a square root of a quotient of the hydraulic compliance of the silencer and a hydraulic mass in a silencer fluid conduit, ω_{HR = √}(K_{Hyd}/M_{Hyd}), wherein ω_{HR} is the Helmholz resonance frequency, K_{Hyd} is the hydraulic compliance of the silencer and M_{Hyd} is the hydraulic mass in the silencer fluid conduit. The Helmholz resonance frequency dip ω_{HR} involves a roll off at a -2 slope. As further depicted in Figure 3C, two silencers in series, e.g. in the supply duct and/or in the return duct, may provide for a resonance peak at a sloshing frequency, the sloshing resonance frequency being equal to a square root of a quotient of [ two times the hydraulic compliance of the silencers and a hydraulic mass in the duct between the two silencer ], (ω_{S =√}(2K_{Hyd/}M_{Hyd}).wherein ω_{S} is the sloshing frequency, 2K_{Hyd} is two times the hydraulic compliance of the silencers and M_{Hyd} is the hydraulic mass in the duct between the silencers. Thus, a silencer pair decouples the hydraulic mass in-between silencers (low stiffness element) achieving a -40 dB/ decade suppression in transfer of pressure over force input (-2 slope) above the sloshing resonance frequency. Multiple silencer pairs (N) allows to benefit from a multitude of decoupled masses resulting into a Nx -40dB/dec. For example, as depicted in Figure 3C, dual pairs provide for two slosing resonance frequencies ω_{S}, providing for a -4 slope. The sloshing resonance frequency ω_{S} may be lower than the Helmholz resonance frequency ω_{HR}, as the larger hydraulic mass of the fluid between the silencers is involved. The sloshing resonance frequency ω_{S} may be dimensioned to be below a disturbance frequency band in which disturbances are to be suppressed, enabling to significantly suppress a propagation of the disturbances as a result of the -2 slope per silencer pair. Tuning the hydraulic mass in-between silencers (***M_hyd***), hydraulic mass in a conduit between the duct and the silencer (***M_hyd***), or the silencer compliancy (***K_hyd*** ) allows to optimize the suppression behavior. Dimensionig the hydraulic mass between the silencers and the silencer compliancy to provide that the sloshing frequencies of the silencer pairs are below the disturbance frequency band may allow to obtain the -2 slope per silencer pair in the disturbance frequency band enabing to suppress the disturbances in the disturbance frequency band by the -2 slope per silencer pair.

In an embodiment, the resonator is a series resonator. The series resonator enables to make use of the mass of the thermal conditioning fluid between the two silencers, hence enabling to use mass that is present in the fluid duct. As a result, no additional mass is required, resulting in little added weight.

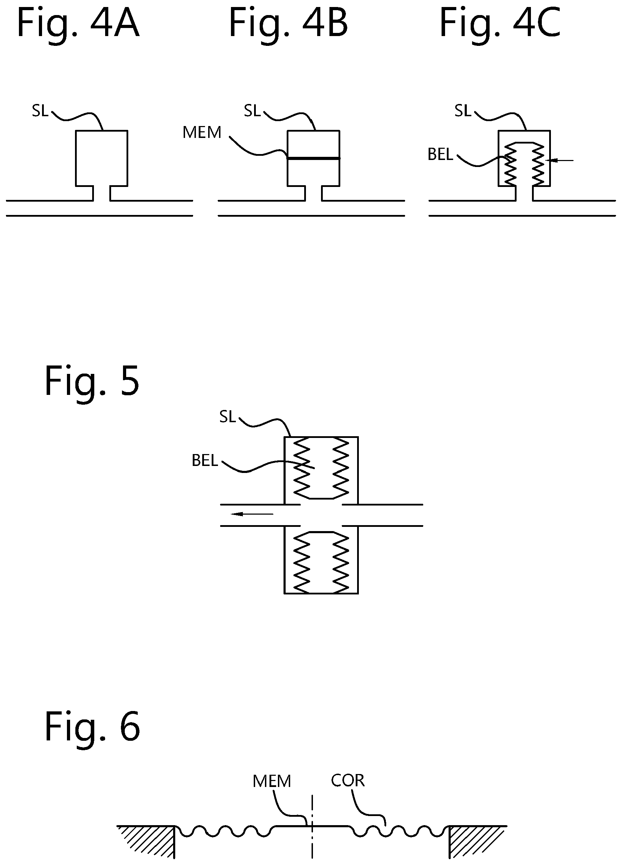

Figures 4A - 4C schematically depict three different embodiments of a silencer. The silencer SL as depicted in Figure 4A is formed by an interior space, which is partly filled with a gas, which gas may refrain from dissolving in the thermal conditioning fluid. A resilience may be formed by the gas when pressurized by the thermal conditioning fluid.

Figure 4B depicts a silencer SL comprising a membrane MEM which divides the interior space of the silencer into a part e.g. filled with a gas and a part filled with thermal conditioning fluid. A resiliency of the membrane, possibly in combination with a pressurizing of the gas, provides for a resiliency of the thermal conditioning fluid interacting with the silencer.

Figure 4C depicts a silencer SL comprising a membrane shaped as a bellow BEL which divides the interior space of the silencer into a part e.g. filled with a gas and a part filled with the thermal conditioning fluid. A resiliency of the membrane shaped as a bellow, possibly in combination with a pressurizing of the gas, provides for a resiliency of the thermal conditioning fluid interacting with the silencer.

Figure 5 depicts a further embodiment of the silencer. As depicted in Figure 5, the silencer comprises a membrane, in the present example shaped as a bellow. The membrane is arranged symmetrically in respect of a fluid flow direction, i.e. a fluid propagation direction, of the fluid duct. Due to the symmetric arrangement, a force distribution by the silencer may be symmetric in respect of a fluid flow direction of the thermal conditioning fluid, thereby at least reducing net, effective forces on the fluid duct. The silencer whereby the membrane is arranged symmetrically in respect of the fluid flow direction may be used in any thermal conditioning system, i.e. the application thereof may not be limited to the thermal conditioning system comprising a fluid supply duct with at least two silencers and a fluid discharging duct with at least to silencers.

Figure 6 depicts a detailed view of a membrane as may be employed in a silencer as described above. The membrane as depicted in Figure 6 has a corrugated shape COR. Due to the corrugated shape of the membrane, a stiffness of the membrane may be reduced. The membrane may for example be manufactured from a metal, providing that the membrane is durable and able to withstand a variety of operating conditions. Using metal however, the membrane may be relatively stiff. The corrugated shape may in part compensate the stiffness, hence arriving at an effective, more desirable compliance. The silencer whereby the membrane with corrugated shape may be used in any thermal conditioning system, i.e. the application thereof may not be limited to the thermal conditioning system comprising a fluid supply duct with at least two silencers and a fluid discharging duct with at least to silencers.

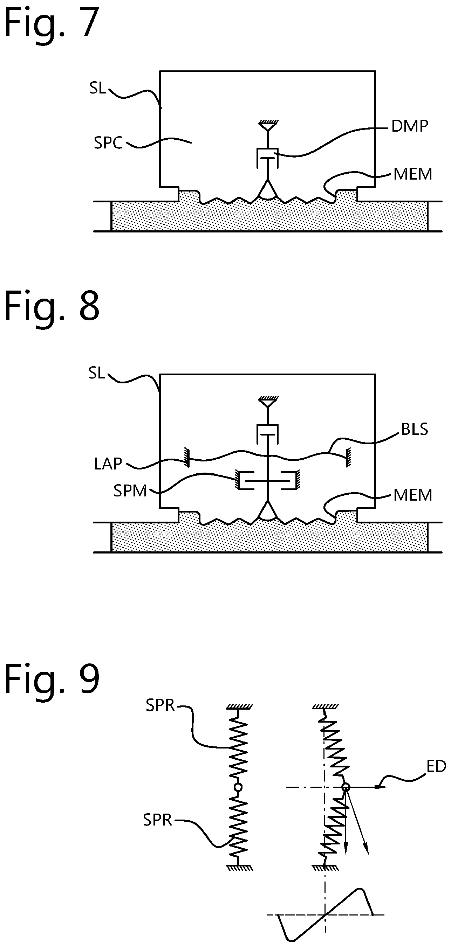

As explained above, the resonance by the at least two silencers in combination with the mass of the thermal conditioning fluid in the duct between the silencers, may provide for a resonance peak in the disturbance transfer via the duct. As the resonance peak may emphasize disturbances at or near the resonance frequency, it may be desirable to add some damping, thus to lower the resonance peak and the corresponding transfer of disturbance via the duct. Accordingly, in an embodiment, each silencer may comprise a damper connected to the membrane. As example is depicted in Figure 7 where the silencer SL comprises a membrane MEM which separates the thermal conditioning fluid from a remaining space SPC in the silencer SL. A damper DMP is connected to the membrane in order to dampen a movement, e.g. vibration, of the membrane. The damper may connect to a fixed part of the silencer, e.g. to a housing or outer wall thereof. The membrane may for example comprise a metal membrane, e.g. having a corrugated shape of a bellow shape. The silencer with the above described damping may be used in any thermal conditioning system, i.e. the application thereof may not be limited to the thermal conditioning system comprising a fluid supply duct with at least two silencers and a fluid discharging duct with at least to silencers. In general, the damper is not restricted to be fixated to the outerworld: in an embodiment, the damper employs deflection of the membrane in itself, e.g. a viscoelastic material applied to the membrane.

In an embodiment, as schematically depicted in Figure 8, each silencer comprises a negative compliance mechanism connected to the membrane. The negative compliance mechanism may reduce a compliance of the membrane. The membrane may for example be manufactured from a metal, providing that the membrane is durable and able to withstand a variety of operating conditions. Using metal however, the membrane may be relatively stiff. The negative compliance may in part compensate the stiffness, hence arriving at an effective, more desirable compliance. The negative compliance may be implemented in various way. For example, Figure 8 depicts a buckled leaf spring BLS, which is attached at leaf spring attachment points LAP. A stroke protection mechanism SPM, such as a stroke limiter, prevents the membrane and buckled leafspring from damage due to excessive excursion.

The buckled leaf spring may form an example of dual compressed springs. Any other implementation of dual compressed springs may be envisaged such as schematically depicted in Figure 9. The dual compressed springs SPR are compressed in a direction substantially parallel to the membrane MEM, i.e. perpendicular to an excursion direction ED of the membrane.

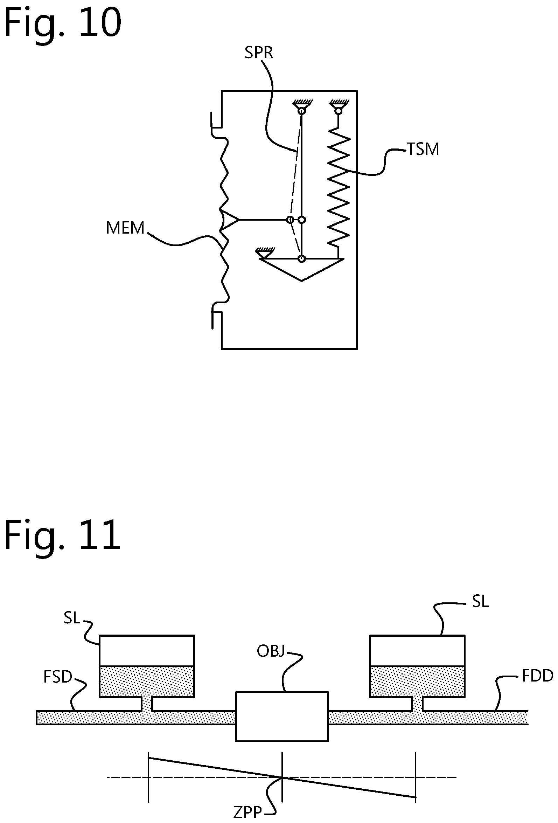

As depicted in Figure 10, in order to tension the dual compressed springs, the negative compliance mechanism may comprise a tensioning member TSM configured to tension the dual compressed springs, in the present example in a direction substantially parallel to the membrane. A tensioning force of the tensioning member may assist to further increase a negative compliance of the dual compressed springs.

The silencer comprising the membrane connected to a negative compliance mechanism, as described above with reference to Figures 8 - 10, may be used in any thermal conditioning system, i.e. the application thereof may not be limited to the thermal conditioning system comprising a fluid supply duct with at least two silencers and a fluid discharging duct with at least to silencers. In yet another embodiment, the negative compliance mechanism as disclosed in Fig. 8-10 may be combined with a self-adjusting silencer as disclosed in EP0679832A1.

A further embodiment will be explained with reference to Figure 11. As depicted in Figure 11, top part, one of the silencers SL in the fluid supply duct FSD, one of the silencers in the fluid discharge duct FDD and the fluid duct interconnecting the one of the silencers in the duct and the one of the silencers in the fluid discharge duct form a further resonator. An excursion of a resonance movement by the further resonator is depicted in Figure 11, bottom part, showing a pressure along the duct between the two silencers. An excursion (i.e. pressure) due to resonance behavior is maximum at the respective silencers SL while reaching a zero pressure point ZPP in between the silencers. In order to reduce a disturbance by a moving mass of the thermal conditioning fluid on the object, the object may be arranged at a zero pressure point ZPP of the further resonator.

In case it would not be possible to have same lengths of the duct between the two silencers and the object, e.g. the mirror, the silencers (compliance and mass) may be tuned to the hydraulic mass of the ducting, in order to obtain the point of zero pressure at the object. For unequal gas volumes, the point of zero pressure where sloshing is not felt, may shift towards the less stiff one of the silencers, e.g. towards the silencer with greater gas volume.

The thermal conditioning system whereby zero pressure point is arranged at the object may be used in any thermal conditioning system with a silencer comprised in the thermal conditioning fluid supply duct and a silencer comprised in the thermal conditioning fluid discharging duct, i.e. the application thereof may not be limited to the thermal conditioning system comprising a fluid supply duct with at least two silencers and a fluid discharging duct with at least two silencers.

According to a further embodiment, diameter variations may be provided in the duct between the two silencers, in order to shift the location of the point of zero pressure to a desired location at the object. A hydraulic mass may increase when the duct diameter and therefore the flow area decreases.

The zero pressure point is preferably located at a center of the object, e.g. the mirror, to minimize an effect of sloshing of the thermal conditioning fluid on the object.

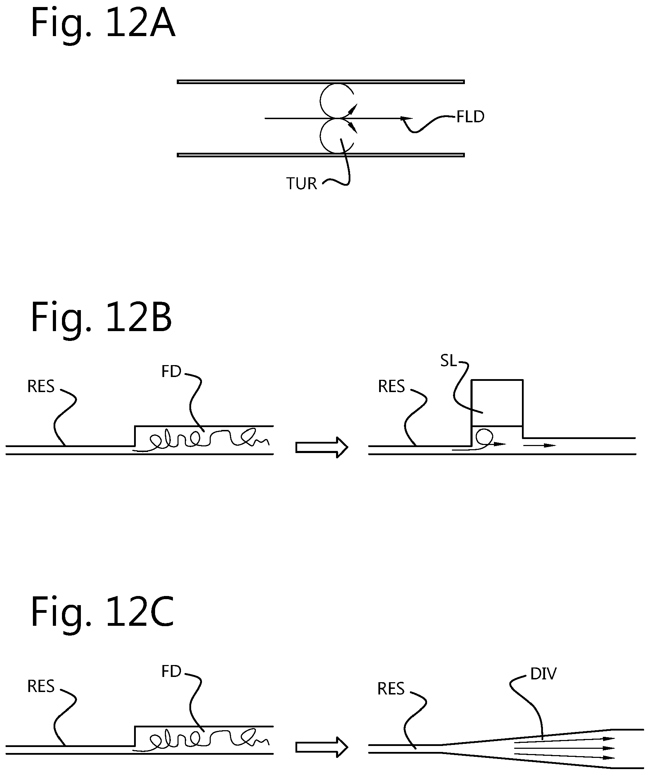

Damping of the movements of the thermal conditioning fluid may be provided by a resistive passage in the fluid duct having a fluid flow resistance which is high in respect of a remainder of the fluid duct. Accordingly, in an embodiment, the fluid duct comprises a resistive passage configured to provide a higher fluid flow resistance in respect of a remainder of the fluid duct. The resistive passage may be arranged between the silencers, which may serve for damping of the resonance peak at the resonance frequency described above. Likewise, the resistive passage may be arranged between a disturbance entry point and at least one of the silencers to reduce a propagation of the disturbance from the disturbance entry point into a remainder of the thermal conditioning fluid duct. Likewise, the resistive passage may be arranged between at least one of the silencers and the object. The resistive passage may for example be implemented by a part of the thermal conditioning fluid duct having a more narrow cross section. An example is depicted in Figure 12B, depicting a resistive, narrow part RES of the fluid duct FD.

As an alternative or additionally to the implementation by a narrower cross section of the duct, the resistive passage may implemented by the fluid duct comprising a porous medium. Accordingly, in an embodiment, the resistive passage of the fluid duct comprises a porous medium. The porous medium may provide the above mentioned damping. The porous medium may be added in-between silencers in the fluid duct, or in a fluid conduit of the silencer between the fluid duct and the membrane.

The narrow cross section may provide a further effect, namely that disturbances caused by turbulence of the thermal conditioning fluid may be shifted to a higher frequency. This higher frequency may be above the frequency range of interest, i.e. above the disturbance frequency band in which a transmission of disturbances is suppressed by the resonance effect. Figure 12A schematically depicts a part of a fluid duct for the thermal conditioning fluid, depicting a flow direction FLD and turbulence TUR resulting from the flow of the thermal conditioning fluid in the fluid duct. The more narrow the cross section of the fluid duct, the higher a frequency of the turbulence TUR may be. In an embodiment, the resonator is configured to attenuate disturbances in a disturbance frequency band, wherein the cross section of the duct is dimensioned to provide that a turbulence frequency band of the thermal conditioning fluid in the duct is above the disturbance frequency band.

As depicted in figure 12C, the connection between the resistive passage RES and the remainder of the fluid duct FD may exhibit a change in the cross section of the fluid duct which may result in turbulence and other effect at the transition of the cross section from the narrow part to the remainder of the fluid supply duct. In order to reduce the turbulence and other effect that may occur at the transition, a diverging section DIV or converging section of the duct may be provided.

As an alternative to the converging or diverging section DIV depicted in Figure 12C, a silencer SL as depicted in Figure 12B may be provided at a connection between the part with the high resistance (e.g. narrow cross section) and the remainder of the fluid duct.

The thermal conditioning system comprising the passage having a higher fluid flow resistance may be used in any thermal conditioning system, i.e. the application thereof may not be limited to the thermal conditioning system comprising a fluid supply duct with at least two silencers and a fluid discharging duct with at least to silencers.

In an embodiment, the membrane comprises a porous membrane to thereby reduce an effective compliance of the silencer. For example, a metal membrane may providing a durable implementation however may be too stiff. A porous membrane, e.g. provided with a plurality of narrow passages, may enable to reduce an effective compliance of the membrane.

The thermal conditioning system described above may be used on a lithographic apparatus. Accordingly, a lithographic apparatus comprising an object and a thermal conditioning system as described above, to thermally condition the object, may be provided. The object may be a projection system mirror of the lithographic apparatus, such as the mirror devices 10, 11 depicted in and described with reference to Figure 1. In another embodiment, the object may be the substrate table WT of the lithographic apparatus, such as the substrate table WT depicted in and described with reference to Figure 1 or a substrate stage of the lithographic apparatus. In yet another embodiment, the object may be a support configured to support a pattering device, such as a mask table of the lithographic apparatus or a mask stage of the lithographic apparatus. In a still further embodiment, the object may be a force frame or a sensor frame of the lithographic apparatus.

In an embodiment, the silencers may be connected to structures of the lithographic apparatus, such as a force frame or a base frame. Accordingly, the resonator formed by the dual silencers and the mass of the thermal conditioning fluid between the silencers may reduce a transfer of a disturbance from one of the structures of the lithographic apparatus via the fluid duct towards another one of the structures of the lithographic apparatus. For example, in the case of the thermal conditioning of a projection system mirror, the fluid duct passes an intermediate frame such as a force frame or a sensor frame of the lithographic apparatus, a base frame of the lithographic apparatus and an interface ring of the lithographic apparatus connected to a metrology frame of the lithographic apparatus. The silencers may be provided at at least one of the intermediate frame, the base frame and the interface ring.

An aspect of the present invention may be phrased as a method of thermally conditioning an object of a lithographic apparatus, comprising providing a flow of a thermal conditioning fluid via a fluid duct to the object, wherein the fluid duct is connected to the object and wherein the fluid duct comprises a supply duct connected to the object to supply the thermal conditioning fluid to the object and a discharging duct connected to the object to discharge the thermal conditioning fluid from the object, wherein the supply duct and the discharging duct are each provided with at least two silencers arranged in series along the supply duct respectively along the discharging duct. With the method according to the present invention, the same or similar advantages and effects may be achieved as with the thermal conditioning system according to an aspect of the invention. Likewise, the same or similar embodiments may be provided, achieving the same or similar effects as described with reference to the thermal conditioning system according to an aspect of the invention.

Although specific reference may be made in this text to the use of lithographic apparatus in the manufacture of Ics, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A thermal conditioning system configured to thermally condition an object, wherein the thermal conditioning system comprises a fluid duct configured to be connected to the object and configured to provide a flow of a thermal conditioning fluid to the object, the fluid duct comprising a supply duct configured to be connected to the object and to supply the thermal conditioning fluid to the object and a discharging duct configured to be connected to the object and to discharge the thermal conditioning fluid from the object, wherein the supply duct and the discharging duct are each provided with at least two silencers arranged in series along the supply duct and along the discharging duct respectively.

2. The thermal conditioning system according to claim 1, wherein the at least two silencers form a resonator with the thermal conditioning fluid in the fluid duct interconnecting the at least two silencers.

3. The thermal conditioning system according to claim 2, wherein the resonator is configured to attenuate disturbances in a disturbance frequency band, wherein a resonance frequency of the resonator is below the disturbance frequency band.

4. The thermal conditioning system according to claim 2 or 3, wherein the resonator is a series resonator.

5. The thermal conditioning system according to any one of the preceding claims, wherein each silencer comprises a membrane configured to interact with the thermal conditioning fluid, the membrane exhibiting a compliance, wherein the membrane is a bellow and wherein preferably the membrane is arranged symmetrically in respect of a fluid flow direction of the fluid duct.

6. The thermal conditioning system according to any one of the preceding claims, wherein each silencer comprises a membrane configured to interact with the thermal conditioning fluid, the membrane exhibiting a compliance and wherein the membrane has a corrugated shape.

7. The thermal conditioning system according to any one of the preceding claims , wherein each silencer comprises a membrane configured to interact with the thermal conditioning fluid, the membrane exhibiting a compliance and wherein each silencer comprises a damper connected to the membrane.

8. The thermal conditioning system according to any one of the preceding claims , wherein each silencer comprises a membrane configured to interact with the thermal conditioning fluid, the membrane exhibiting a compliance and wherein each silencer comprises a negative compliance mechanism connected to the membrane.

9. The thermal conditioning system according to claim 8, wherein the negative compliance mechanism comprises dual compressed springs.

10. The thermal conditioning system according to claim 8 or 9, wherein the negative compliance mechanism comprises a tensioning member connected to the membrane.

11. The thermal conditioning system according to any one of the preceding claims , wherein one of the silencers in the supply duct, one of the silencers in the discharge duct and the fluid duct interconnecting the one of the silencers in the supply duct and the one of the silencers in the discharge duct form a further resonator, wherein the object is arranged at a zero pressure point of the further resonator.

12. The thermal conditioning system according to any one of the preceding claims, wherein the fluid duct comprises a resistive passage configured to provide a higher fluid flow resistance in respect of a remainder of the fluid duct.

13. The thermal conditioning system according to claim 12, wherein the resistive passage is arranged between the silencers or between a disturbance entry point and at least one of the silencers or between at least one of the silencers and the object.

14. The thermal conditioning system according to claim 12 or 13, wherein a connection between the resistive passage and the remainder of the fluid duct is a diverging section or converging section of the duct.

15. The thermal conditioning system according to any one of claims 12 - 14, wherein the resistive passage of the fluid duct comprises a porous medium.

16. The thermal conditioning system according to any one of the preceding claims, wherein the resonator is configured to attenuate disturbances in a disturbance frequency band and wherein the cross section of the duct is dimensioned to provide that a turbulence frequency band of the thermal conditioning fluid in the duct is above the disturbance frequency band.

17. The thermal conditioning system according to any one of the preceding claims, wherein the membrane comprises a porous membrane.

18. A lithographic apparatus comprising an object and a thermal conditioning system according to any one of the preceding claims to thermally condition the object, wherein the object is one of a projection system mirror, a substrate table, a support to support a pattering device, a force frame and a sensor frame of the lithographic apparatus.

19. The lithographic apparatus according to claim 18, wherein the object is the projection system mirror and wherein the fluid duct passes an intermediate frame such as a force frame or a sensor frame of the lithographic apparatus, a base frame of the lithographic apparatus and an interface ring of the lithographic apparatus connected to a metrology frame of the lithographic apparatus, wherein the silencers are provided at at least one of the intermediate frame, the base frame and the interface ring.

20. A method of thermally conditioning an object of a lithographic apparatus, comprising providing a flow of a thermal conditioning fluid via a fluid duct to the object, wherein the fluid duct is connected to the object and wherein the fluid duct comprises a supply duct connected to the object to supply the thermal conditioning fluid to the object and a discharging duct connected to the object to discharge the thermal conditioning fluid from the object, wherein the supply duct and the discharging duct are each provided with at least two silencers arranged in series along the supply duct respectively along the discharging duct.
